# EUROPEAN PATENT APPLICATION

(11) **EP 4 502 536 A1**
(43) Date of publication of application: **05.02.2025**
(21) Application number: 24192288.9
(22) Date of filing: 01.08.2024
(51) Int. Cl.: G01C 19/5712, G01C 19/5733, B81B 3/00, G01P 15/097, B81C 1/00, H03H 9/02, G01P 15/08

(54) **MICROELECTROMECHANICAL DEVICE WITH RECOVERY FROM STICTION CONDITIONS**

(30) Priority: 04.08.2023 IT 202300016743
(71) Applicant: STMicroelectronics International N.V., 1228 Plan-les-Ouates, Geneva (CH)
(72) Inventor: RIANI, Manuel, 22100 COMO (IT); VALZASINA, Carlo, 20060 GESSATE (MI) (IT); YALLICO SANCHEZ, Gianfranco Javier, 20089 ROZZANO (MI) (IT); GUERINONI, Luca, 24022 ALZANO LOMBARDO (BG) (IT)
(74) Representative: Studio Torta S.p.A.

(57) **Abstract**

A MEMS (MicroElectroMechanical System) device includes: a supporting body (10); a movable mass (11), constrained to the supporting body (10) by flexures (12; 512) so as to be able to oscillate in a main direction (X); an actuator device (8, 18), configured to apply to the movable mass (11) an electrostatic actuation force (F_{A}), transverse to the main direction (X); and a control circuit (9) configured to detect stiction conditions, in which the movable mass (11) is stuck to the supporting body (10) by a stiction force (F_{S}), and for driving the actuator device (8, 18) in response to recognition of the stiction conditions. The actuation force (F_{A}) is an oscillating variable force with an actuation frequency band (ΔF_{A}) containing at least one resonance frequency (F_{R}), in an actuation direction transverse to the main direction (X), of a mechanical system comprising the movable mass (11) stuck to the supporting body (10), so that the actuation force (F_{A}) will activate at least one natural vibrational mode in a vibration direction transverse to the main direction (X).

## Description

### Technical field

The present invention relates to a MEMS (MicroElectroMechanical System) device with recovery from stiction conditions.

### Context

As is known, MEMS devices, such as accelerometers and gyroscopes, normally use movable masses connected to a supporting body by elastic connections or flexures. The flexures allow oscillation of the movable mass in one or more directions in response to external stresses or else in response to action of a driving device, as in gyroscopes.

Following upon intense stresses, it may happen that the movable mass comes into contact with the supporting structure and sticks thereto without being able to return spontaneously into its own resting position. The energy yielded in the impact may create surface bonds that it is necessary to break by applying an appropriate additional force to release the movable mass, because the elastic force of the connections may not be sufficient.

The phenomenon, known as "stiction", is relatively frequent in MEMS devices and, even though it is more common in accelerometers, it is not excluded also in gyroscopes, both in the driving part and in the sensing part. Accelerometers are in any case more likely to be subject to the problem because the flexures are less stiff in order to allow wider oscillations given the same amplitude of the loads, and thus a higher sensitivity.

The problem of stiction is serious and is particularly felt because it may jeopardize operation of the MEMS device. Evidently, as long as the movable mass sticks to the supporting body, the MEMS device is not in a condition to operate, and not always may functionality of the movable mass be restored.

A known solution consists in applying an electrostatic force contrary to the stiction force of the movable mass to the supporting body. In general, the stiction force is parallel to the main direction of oscillation of the movable mass and may be overcome, for example, using the same electrodes that normally serve for detection. In many cases, however, this intervention does not provide a conclusive solution. In fact, the very force necessary to separate the movable mass from the supporting body is in actual fact sufficient to cause stiction of the movable mass on the opposite side of the supporting body, and functionality of the MEMS device may not in effect be restored.

### Summary

Consequently, the aim of the present invention is to provide a MEMS device and a method for controlling a MEMS device that will make it possible to overcome or at least mitigate the limitations described.

According to the present invention, a MEMS device and a method for controlling a MEMS device are provided, as defined in claims 1 and 15, respectively.

### Brief description of the drawings

For a better understanding of the present invention, preferred embodiments thereof are described, by way of nonlimiting example, with reference to the attached drawings, wherein:
- Figure 1 is a simplified block diagram of a MEMS device according to one embodiment of the present invention;
- Figure 2 is a graph showing quantities regarding the MEMS device of Figure 1;
- Figure 3 is a top plan view of a part of the MEMS device of Figure 1, in a first operating configuration;
- Figure 4 is a top plan view of the part of Figure 3, in a second operating configuration;
- Figures 5-7 are graphs showing quantities regarding the MEMS device of Figure 1;
- Figure 8 is a simplified block diagram of a MEMS device according to a different embodiment of the present invention;
- Figure 9 is a graph showing quantities regarding the present invention;
- Figure 10 is a cross-sectional view through a MEMS device according to another embodiment of the present invention;
- Figure 11 is a cross-sectional view through a MEMS device according to a further embodiment of the present invention;
- Figure 12 is a top plan view of a part of a MEMS device according to a further embodiment of the present invention, in a first operating configuration;
- Figure 13 is a top plan view of the part of Figure 12, in a second operating configuration;
- Figure 14 is a top plan view of a part of a MEMS device according to a further embodiment of the present invention; and
- Figure 15 is a cross-sectional view through the MEMS device of Figure 14.

### Description of embodiments

The ensuing description refers to the layout illustrated in the drawings; consequently, terms such as "above", "underneath", "top", "bottom", "up", "down", "right", "left", and the like regard the attached figures and are not to be interpreted in a limiting way.

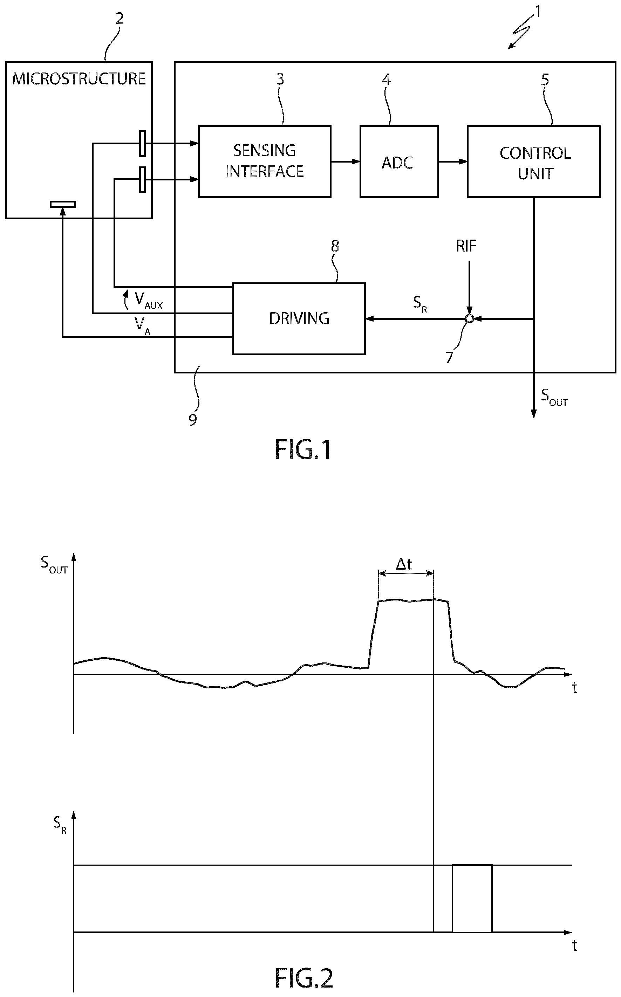

With reference to Figure 1, a MEMS device is designated as a whole by the number 1 and comprises a microstructure 2, a sensing interface 3, an analog-to-digital converter 4, a control unit 5, a comparator stage 7, and a driving stage 8. The sensing interface 3, the analog-to-digital converter 4, the control unit 5, the comparator stage 7, and the driving stage 8 may be components of a dedicated integrated circuit or ASIC (Application-Specific Integrated Circuit) 9 coupled to the microstructure 2.

As specified hereinafter, in an embodiment to which reference will be made for simplicity, the MEMS device 1 is a linear uniaxial accelerometer of an in-plane type, with a mass that is movable along a sensing axis with respect to a supporting body (which are not illustrated in Figure 1) . The MEMS device 1 may, however, be any device provided with a mass movable with respect to a supporting body. In particular, the MEMS device 1 may be an inertial sensor, for example, a uniaxial accelerometer of the out-of-plane (or teeter-totter) type, a rotational accelerometer, a multiaxial accelerometer, a uniaxial or multiaxial gyroscope. Furthermore, the movable mass is in general a sensing mass or seismic mass, but it may also be a driving mass of a gyroscope.

The sensing interface 3 receives sensing signals from a first sensing terminal 2a and from a second sensing terminal 2b, respectively, of the microstructure 2 and supplies amplified read signals, which may be used by the analog-to-digital converter 4 for generating digital sensing signals.

The control unit 5 processes the digital sensing signals and supplies an output signal S_{OUT} indicating a quantity detected through the microstructure 2, here a linear acceleration according to the sensing axis.

The comparator stage 7 compares the output signal S_{OUT} with a reference value REF, which indicates an end-of-travel position of the movable mass, and, when a stiction condition is recognized on the basis of the comparison, generates a recovery signal S_{R}. When the recovery signal S_{R} indicates that a stiction condition has been recognized, the driving stage 8 applies an actuation voltage V_{A} to a recovery terminal 2c of the microstructure 2. The actuation voltage V_{A} is controlled so as to produce forces that cause detachment of the movable mass, as clarified hereinafter. In one embodiment, the recovery signal S_{R} may be generated, for example, when the comparison indicates that the movable mass has remained in the end-of-travel position for a time longer than a threshold, as illustrated in Figure 2. Optionally, the driving stage 8 may generate an auxiliary actuation voltage V_{AUX}, which is applied to the sensing terminals 2a, 2b of the microstructure 2 and produces auxiliary forces to facilitate detachment of the movable mass.

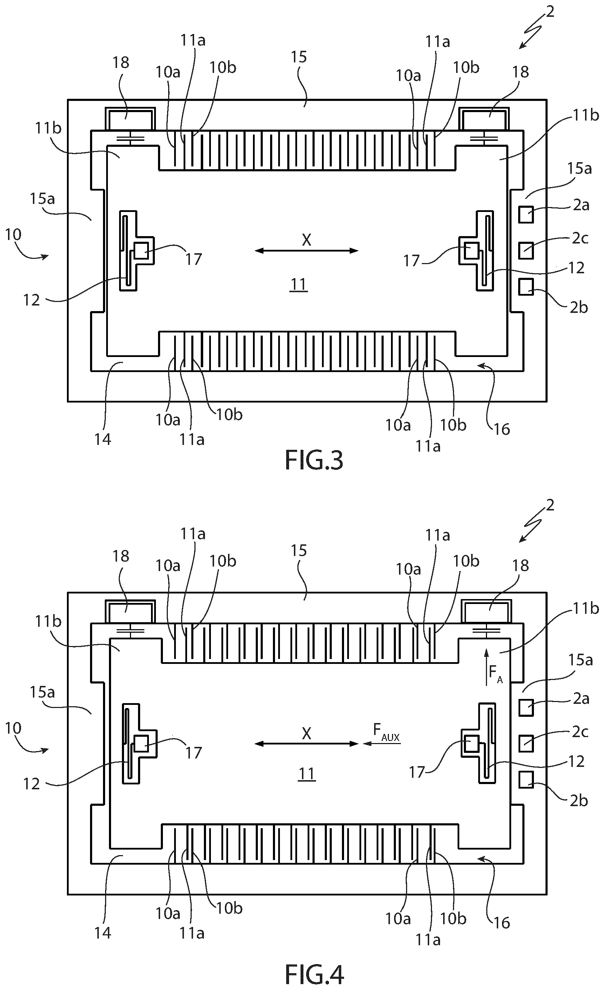

Figures 3 and 4, where the supporting body is designated by 10 and the movable mass by 11, show the microstructure 2 in a resting position and in a stiction condition, respectively. In the stiction condition, the movable mass 11 is withheld in an end-of-travel position (on the right, by way of example in Figure 4, but a similar situation may occur on the opposite side) by stiction forces FA.

In detail, the movable mass 11 is connected to the supporting body 10 by flexures or flexures 12 configured so that the movable mass 11 will be able to oscillate with respect to the supporting body in a main direction X, which here coincides with the sensing axis of the MEMS device 1. In particular, the main direction X is parallel to a major face of the movable mass 11, and the movement of the movable mass 11 is of the in-plane type.

The supporting body 10 may comprise, for example, a substrate 14 of semiconductor material and a frame structure 15, defining a cavity 16 in which the movable mass 11 is housed. The frame structure 15 is provided with stopper structures 15a adjacent to the side of the movable mass 11 opposite with respect to the main direction X. The stopper structures 15a thus limit the movement of the movable mass 11 both in the main direction X (to the right, in Figures 3 and 4) and in an opposite direction (to the left, in Figures 3 and 4).

In the embodiment of Figures 3 and 4, the supporting body 10 and the movable mass 11 are capacitively coupled by sensing electrodes in a parallel-plate configuration. Alternatively, the sensing electrodes may, for example, be in comb-fingered configuration. In greater detail, the supporting body 10 comprises first fixed sensing electrodes 10a and second fixed sensing electrodes 10b, coupled, respectively, to the first sensing electrode 2a and to the second sensing electrode 2b and defined by respective semiconductor plates perpendicular to the main direction X. The first fixed sensing electrodes 10a and the second fixed sensing electrodes 10b are arranged alternating and extend from the supporting frame 15 in the cavity 16 towards respective sides of the movable mass 11 parallel to the main direction X.

The movable mass 11 is biased in a known way at an operating potential through the flexures 12 and respective anchorages 17, which are defined by portions of the frame structure 15 electrically insulated from the rest of the supporting body 10 and connected to an external biasing source through connection lines, here not illustrated for reasons of simplicity.

The movable mass 11 is further provided with movable sensing electrodes 11a, which are themselves also defined by semiconductor plates perpendicular to the main direction X. The movable sensing electrodes 11a extend from the sides of the movable mass 11 parallel to the main direction X towards the frame structure 15 and are each arranged between a respective fixed sensing electrode 10a and a respective second fixed sensing electrode 10b, thus forming parallel-plate capacitors with capacitance that is variable in a differential way as a function of the position of the movable mass 11.

The stopper structures 15a are shaped so as to stop the movable mass 11 before the movable sensing electrodes 11a come into contact with the first fixed sensing electrodes 10a or the second fixed sensing electrodes 10b, according to the direction of movement of the movable mass 11.

In conditions of stiction of the movable mass 11 to the supporting body 10, in particular, to the frame structure 15, the capacitive coupling between the fixed sensing electrodes 10a, 10b and the fixed electrodes 11a may be exploited for applying an auxiliary force F_{AUX} to the movable mass 11 in the main direction X, by the auxiliary actuation voltage V_{AUX}.

The microstructure 2 is further provided with recovery electrodes 18, arranged on the supporting body 10 and coupled to the recovery terminal 2c by connection lines (not illustrated for reasons of simplicity). In the embodiment of Figures 3 and 4, in particular, the recovery electrodes 18 are arranged on the frame structure 15 in positions corresponding to respective recovery portions 11b of the movable mass 11 at opposite ends of the movable mass 11 in the main direction X. In the embodiment of Figures 3 and 4, the recovery electrodes 18 face only one side of the movable mass 11, but could be arranged differently according to the design preferences. In some embodiments, there may be present only one recovery electrode 18.

The recovery electrodes 18 and the respective recovery portions 11b of the movable mass 11 are capacitively coupled and are shaped so that the recovery voltage V_{R} applied in response to a recovery signal S_{R} causes a transverse actuation force F_{A} in an actuation direction D_{A} transverse to the main direction X and having at least one normal component, perpendicular to the main direction X. In the embodiment of Figures 3 and 4, the transverse actuation force F_{A} is substantially perpendicular to the main direction X, coincides with the normal component, and is further parallel to a major face of the movable mass 11. It is, however, understood that the actuation force F_{A} may present also a different orientation.

The recovery portions 11b of the movable mass 11 may be patterned so that the capacitive coupling with the respective recovery electrodes 18 will meet design preferences.

In practice, the driving stage 8 and the recovery electrodes 18 define an actuator device that applies the actuation force F_{A} to the movable mass 11 so as to cause detachment from the frame structure 15.

In a condition of stiction of the movable mass 11 to the supporting body 10, the movable mass 11 constrained to the stopper structures 15a and the flexures 12 form a mechanical system that has different natural vibration modes, amongst which also natural vibration modes transverse to the main direction X (translational, torsional, or else combined translational and torsional, according to the conformation of the flexures 12). In other words, response of the mechanical system to the loads transverse to the main direction X is resonant around given frequencies, and, given the same energy received, at the resonance frequencies the vibrations have a greater amplitude.

Advantageously, the actuation voltage V_{A} is controlled by the driving stage 8 so that the actuation force F_{A} will activate at least one natural vibrational mode in a vibration direction transverse to the main direction X. In practice, the actuation voltage V_{A} is an oscillating voltage variable with a frequency band containing at least one resonance frequency of the mechanical system that comprises the movable mass 11 stuck to the supporting structure 15. Furthermore, for the configuration of the recovery electrodes 18 and of the recovery portions 11b of the movable mass 11 that face them, the transverse actuation force F_{A} caused by the actuation voltage V_{A} is transverse, here substantially perpendicular, to the main direction X. It is noted that the actuation direction D_{A} does not need to be strictly parallel to the vibration direction in order to activate the at least one natural vibrational mode. In fact, it is sufficient that the actuation force F_{A} has a component parallel to the vibration direction to transfer energy and activate the vibration mode.

For this purpose various embodiments are possible.

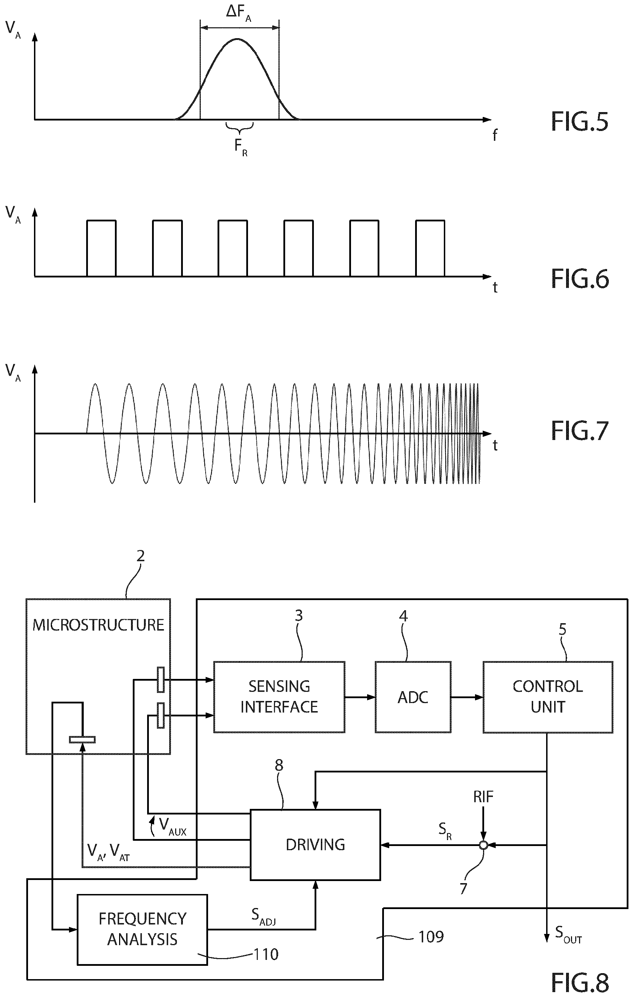

In a first case, the natural vibrational modes may be analyzed with simulations or on samples to determine the position of at least one resonance frequency F_{R}. The driving stage 8 may be configured to generate the actuation voltage V_{A} with an actuation frequency band ΔF_{A} that comprises the resonance frequency F_{R}, as illustrated in Figure 5. The position and amplitude of the actuation frequency band ΔF_{A} may be selected as a function of the spread of the resonance frequency F_{R} detected during the analysis step. In addition, the driving stage 8 may be configured to apply the actuation voltage V_{A} at intervals. If, at the end of each interval, the comparator stage 7 indicates that the stiction situation remains, the driving stage 8 generates a new voltage interval; otherwise, the MEMS device 1 returns to the normal operating conditions.

In a different embodiment (Figure 6), the driving stage 8 may be configured to generate the actuation voltage V_{A} as a sequence of pulses or a square wave.

In another embodiment (Figure 7), the driving stage 8 generates the actuation voltage V_{A} so as to carry out a frequency scan in a programmed recovery range, for example, comprised between 1 and 200 kHz.

According to a further embodiment (illustrated in Figure 8), the MEMS device 1 may be provided with components for determining the frequency response of the mechanical system formed by the supporting body 10, the movable mass 11, and the flexures 12 in stiction conditions. For instance, the dedicated integrated circuit, here designated by 109, may comprise a frequency-analysis stage 110 having an input coupled to a recovery terminal 2c of the microstructure 2 and an output that supplies an adjustment signal S_{ADJ} to the driving stage 8. In this case, when the comparator stage 7 recognizes a stiction situation, the driving stage 8 applies a test voltage V_{AT} to the recovery terminal 2c of the microstructure 2, for example a voltage pulse in response to a command issued by the control unit 5. The frequency-analysis stage 110 detects the voltage produced at the recovery terminal 2c as a result of the oscillations of the movable mass 11 in response to the applied test voltage V_{AT}, and determines the spectral content thereof, in particular one or more resonance frequencies. The adjustment signal S_{ADJ} is used for adapting the spectrum of the actuation voltage V_{A} on the basis of the result of the analysis conducted by the frequency-analysis stage 110, so that the actuation frequency band ΔF_{A} of the actuation force F_{A} contains the at least one resonance frequency F_{R}. The adjustment signal S_{ADJ} may present any useful form; for example, it may be a reference or else contain a list of identified resonance frequencies.

It is understood that the embodiments described above may be combined for generating the actuation voltage V_{A} in one or more modalities according to the design preferences.

Application of an oscillating actuation force F_{A} transverse to the main direction X contributes to breaking the chemico-physical bonds that are created at the moment of impact of the movable mass 11 against the supporting body 10 (in particular, the stopper structures 15a of the frame structure 15) and that cause stiction. The effect is amplified by the fact that the transverse actuation force F_{A} is applied so as to activate a natural transverse vibrational mode of the mechanical system that includes the supporting body 10 and the movable mass 11 in stiction conditions. This enables limitation of the energy to be transferred to the movable mass 11 to obtain separation or, conversely, increase in the effect of separation given the same energy employed.

As already mentioned, however, simultaneously with the actuation voltage V_{A}, the driving stage 8 may apply an auxiliary actuation voltage V_{AUX} to the sensing terminals 2a, 2b of the microstructure 2 in order to produce auxiliary forces F_{AUX} in the main direction X and facilitate detachment of the movable mass 11 from the frame structure 15. In practice, as a result of the transverse actuation force F_{A} and of the auxiliary forces F_{AUX}, the movable mass 11 is subjected to a resulting force F_{R} that has a normal component F_{RN} (coincident with the normal component of the transverse actuation force F_{A}) and a parallel component F_{RP} that are, respectively, perpendicular and parallel to the main direction X. The parallel component F_{RP} may in particular coincide with the auxiliary force F_{AUX}, if present, or else may comprise a normal component of the transverse actuation force F_{A}, considering that the transverse actuation force F_{A} is not necessarily perpendicular to the main direction.

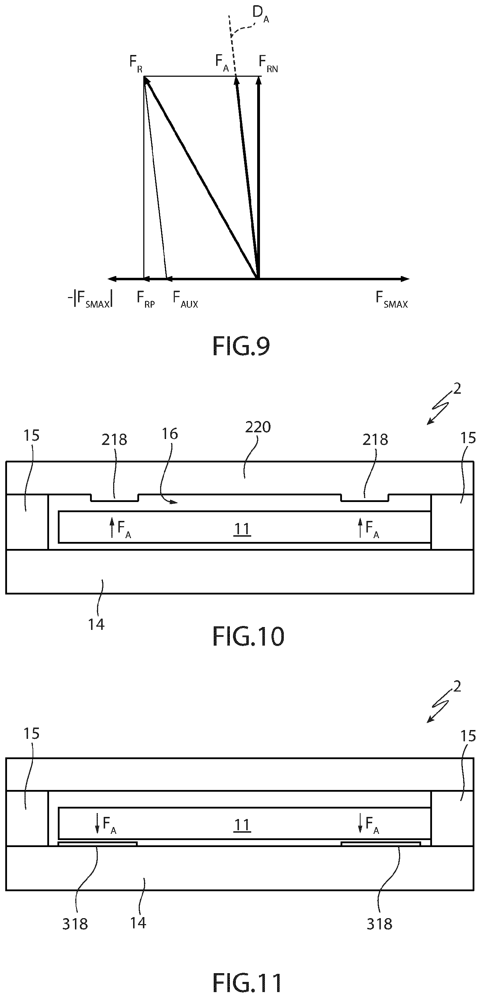

The transverse actuation force F_{A} and the auxiliary force F_{AUX} are selected so that the parallel component F_{RP} of the resulting force F_{R} (Figure 9) will always be less in modulus than the maximum stiction force F_{SMAX} in the main direction X. In this way, the auxiliary force F_{AUX} cooperates in releasing the movable mass 11, but is not so intense as to cause stiction on the opposite side of the supporting body 10. In addition to the resulting force F_{R} due to the transverse actuation force F_{A} and to the (possible) auxiliary force F_{AUX}, also forces of inertia due to the movement of the accelerometer 1 and here not represented may contribute even significantly to detachment of the movable mass 11 from the supporting body 10.

According to an embodiment illustrated in Figure 10, where parts that are the same as those already represented are designated by the same reference numbers, the microstructure 2 comprises a cap 220 that closes the cavity 16 and is provided with electrical connections (not illustrated) for receiving the actuation voltage V_{A} from the driving stage 8 (which is not illustrated here either). A side of the cap 220 facing the movable mass 11 is provided with protrusions that define recovery electrodes 218 capacitively coupled to the movable mass 11. Also in this case, an actuation voltage V_{A} applied between the recovery electrodes 218 and the movable mass 11 causes a transverse actuation force F_{A} substantially perpendicular to the main direction X (in this case perpendicular also to the major faces of the movable mass 11).

According to the embodiment illustrated in Figure 11, recovery electrodes 318 are arranged on the substrate 14 of the microstructure 2 and are capacitively coupled to the movable mass 11. As in the example of Figure 10, an actuation voltage V_{A} applied between the recovery electrodes 318 and the movable mass 11 causes a transverse actuation force F_{A} substantially perpendicular to the main direction X and perpendicular also to the major faces of the movable mass 11.

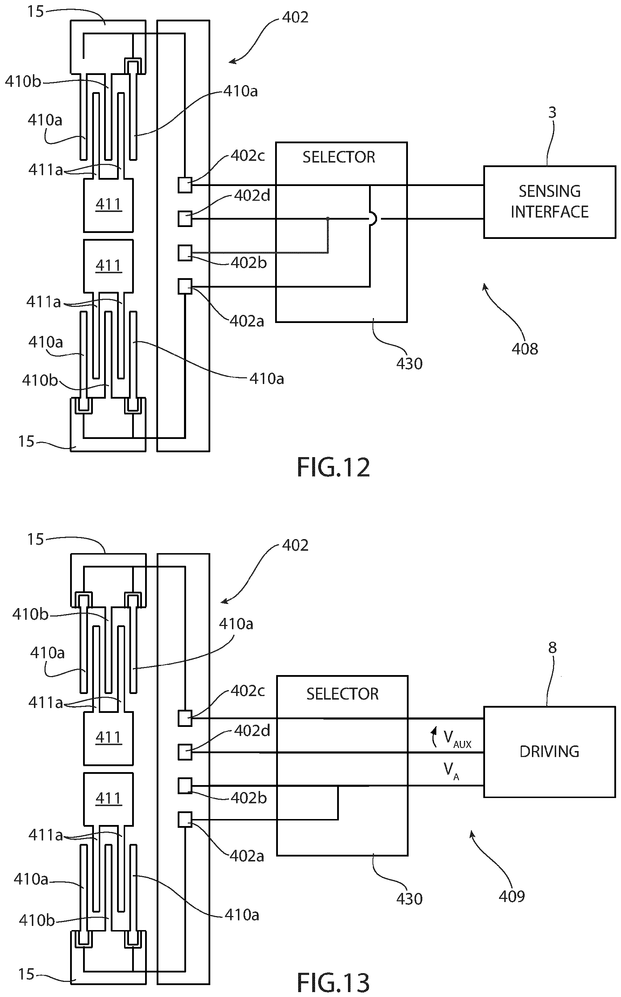

A further embodiment is illustrated in Figures 12 and 13. In this case, the microstructure, here designated by 402, is substantially identical to the microstructure 2 described previously, but has a first set of first fixed sensing electrodes 410a and second fixed sensing electrodes 410b, respectively, connected to a first sensing terminal 402a and to a second sensing terminal 402b, and a second set of first fixed sensing electrodes 410a and second fixed sensing electrodes 410b, respectively, connected to a third sensing terminal 402c and to a fourth sensing terminal 402d. For instance, the first set comprises the first fixed sensing electrodes 410a and the second fixed sensing electrodes 410b on a first side of the movable mass 411, and the second set comprises the first fixed sensing electrodes 410a and the second fixed sensing electrodes 410b on a second side of the movable mass 411.

The first fixed sensing electrodes 410a and the second fixed sensing electrodes 410b of the first set are used as actuation electrodes for applying to the movable mass 410 transverse actuation forces F_{A} substantially perpendicular to the main direction X. For this purpose, the dedicated integrated circuit, here designated by 409, comprises a selector 430, configured to connect the sensing terminals 402a-402d to the sensing interface 3 and to the driving stage 8 in different operating conditions. In detail, in normal operating conditions (i.e., in the absence of conditions of stiction of the movable mass 411) the selector 430 connects the first sensing terminal 402a and the third sensing terminal 402c (and thus all the first fixed sensing electrodes 410a) to a first input of the sensing interface 3, and connects the second sensing terminal 402b and the fourth sensing terminal 402d (and thus all the second fixed sensing electrodes 410b) to a second input of the sensing interface 3. The MEMS device is in sensing configuration, and the capacitive coupling between the movable mass 411 and the supporting body 410 is of a parallel-plate type.

In stiction conditions, the selector 430 connects the first sensing terminal 402a and the second sensing terminal 402b (and thus all the first fixed sensing electrodes 410a and the second fixed sensing electrodes 410b of the first set) to a terminal of the driving stage 8 that supplies the actuation voltage V_{A}, and connects the third sensing terminal 402c (and thus all the first fixed sensing electrodes 410a of the second set) and the fourth sensing terminal 402c (and thus all the second fixed sensing electrodes 410b of the second set) to terminals of the driving stage 9 that supply the auxiliary actuation voltage V_{AUX}. Consequently, all the first fixed sensing electrodes 410a and the second fixed sensing electrodes 410b of the first set receive the same actuation voltage V_{A} and are coupled to the movable mass 411 in comb-fingered configuration. As a result of the comb-fingered configuration, the actuation voltage V_{A} causes a transverse actuation force F_{A} on the movable mass 411 in a direction substantially perpendicular to the main direction X.

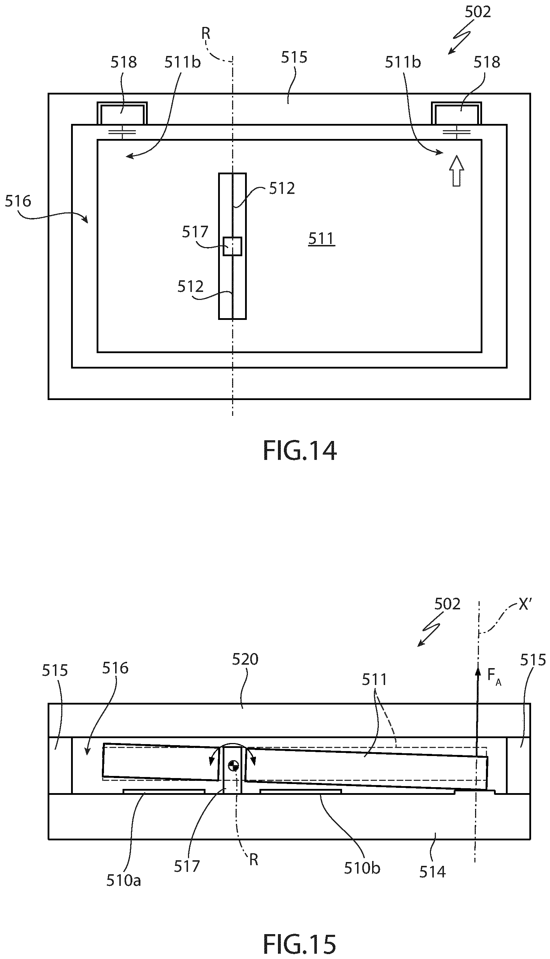

Figures 14 and 15 illustrate a microstructure 502 of a MEMS device according to a further embodiment of the present invention, which comprises a dedicated integrated circuit (not illustrated) substantially as already described. The microstructure 502 comprises a supporting body 510 and a movable mass 511. The supporting body 510 includes a substrate 514 and a frame structure 515, which defines a cavity 516 where the movable mass 511 is housed. A cap 520 closes the cavity 516 on a side opposite to the substrate 514.

The movable mass 511 is supported by an anchorage 517 and by flexures 512 in a way rocking about a non-centroidal axis of rotation R that is parallel to major faces of the movable mass 511. The movement of the movable mass 511 is thus of the out-of-plane type.

A first sensing electrode 510a and a second sensing electrode 510b are arranged on the substrate 514 in positions that are symmetrical with respect to the axis of rotation R and are capacitively coupled to the movable mass 511, which functions as movable sensing electrode.

The microstructure 502 is further provided with recovery electrodes 518, arranged on the supporting body 510 and coupled to a recovery terminal 502c by connection lines (not represented for reasons of simplicity). In the embodiment of Figures 14 and 15, in particular, the recovery electrodes 518 are arranged on the frame structure 515 in positions corresponding to respective recovery portions 511b of the movable mass 511 at ends of the movable mass 511 opposite to the axis of rotation R.

The recovery electrodes 518 and the respective recovery portions 511b of the movable mass 511 are capacitively coupled and are shaped so that a recovery voltage V_{R} applied in response to a recovery signal S_{R} will bring about a transverse actuation force F_{A} having at least one normal component perpendicular to a main direction X' of movement. Given that the movable mass 11 is coupled to the supporting body so as to oscillate about the axis of rotation R, the main direction X' of movement is perpendicular to the axis of rotation R.

Finally, it is clear that modifications and variations may be made to the device and method described herein, without thereby departing from the scope of the present invention, as defined in the annexed claims.

For instance, the number and arrangement of the recovery electrodes are not limited to the configurations described, but may be chosen on the basis of the design preferences, in particular according to the shape, dimensions, and type of movement of the movable mass.

For the actuation voltage, the MEMS device may use more than one waveform capable of activating natural vibrational modes in a direction transverse to the main direction, either chosen from among the ones described or of some other kind.

The MEMS device may also be of a multiaxial type, whether in-plane or out-of-plane. In this case, at least one recovery electrode for each main direction is associated to the movable mass.

## Claims

1. A MEMS (MicroElectroMechanical System) device comprising:
a supporting body (10; 410; 510);
a movable mass (11; 411; 511), constrained to the supporting body (10; 410; 510) by flexures (12; 512) so as to be able to oscillate in a main direction (X; X');
an actuator device (8, 18; 8, 218; 8, 318; 8, 518), configured to apply to the movable mass (11; 411; 511) an electrostatic actuation force (F_{A}), transverse to the main direction (X; X'); and
a control circuit (9; 109; 409) configured to detect stiction conditions, in which the movable mass (11; 411; 511) is stuck to the supporting body (10; 410; 510) by a stiction force (F_{S}), and to drive the actuator device (8, 18; 8, 218; 8, 318; 8, 518) in response to recognition of the stiction conditions;
wherein the actuation force (F_{A}) is a variable force with an actuation frequency band (ΔF_{A}) containing at least one resonance frequency (F_{R}), in an actuation direction (D_{A}) transverse to the main direction (X; X'), of a mechanical system comprising the movable mass (11; 411; 511) stuck to the supporting body (10; 410; 510), so that the actuation force (F_{A}) will activate at least one natural vibrational mode in a vibration direction transverse to the main direction (X).

2. The device according to claim 1, wherein the actuator device (8, 18; 8, 218; 8, 318; 8, 518) comprises:
at least one recovery electrode (18; 218; 318; 518), capacitively coupled to the movable mass (11; 411; 511) and configured to apply to the movable mass (11; 411; 511) the actuation force (F_{A}) in the actuation direction (D_{A}) in response to an oscillating actuation voltage (V_{A}); and
a driving stage (8) configured to supply the actuation voltage (V_{A}) to the at least one recovery electrode (18; 218; 318; 518).

3. The device according to claim 2, wherein the actuation voltage (V_{A}) is a pulsed voltage or a square-wave voltage.

4. The device according to claim 2 or claim 3, wherein the driving stage (8) generates the actuation voltage (V_{A}) so as to carry out a frequency scan in a programmed recovery range.

5. The device according to any one of claims 2 to 4, wherein the control circuit (9; 109; 409) is configured to determine a frequency response of the mechanical system comprising the movable mass (11; 411; 511) stuck to the supporting body (10; 410; 510) and wherein the driving stage (8) is configured to adapt a spectrum of the actuation voltage (V_{A}) as a function of the frequency response determined, so that the actuation frequency band (ΔF_{A}) of the actuation force (F_{A}) contains the at least one resonance frequency (F_{R}).

6. The device according to claim 5, wherein the driving stage (8) is configured to apply a test voltage (V_{AT}) to the at least one recovery electrode (18), and the control circuit (109) comprises a frequency-analysis stage (110) having an input coupled to the at least one recovery electrode (18) and configured to detect a voltage produced as a result of oscillations of the movable mass (11) in response to the test voltage (V_{AT}) and to supply an adjustment signal (S_{ADJ}) to the driving stage (8) as a function of the voltage detected, whereby the spectrum of the actuation voltage (V_{A}) is adapted as a function of the frequency response determined, so that the actuation frequency band (ΔF_{A}) of the actuation force (F_{A}) contains the at least one resonance frequency (F_{R}).

7. The device according to any one of claims 2 to 6, wherein the supporting body (10; 410; 510) comprises first fixed sensing electrodes (10a; 410a; 510b) and second fixed sensing electrodes (10b; 410b; 510b), and the movable mass comprises movable sensing electrodes (11a) capacitively coupled to respective first fixed sensing electrodes (10a; 410a; 510b) and second fixed sensing electrodes (10b; 410b; 510b) .

8. The device according to claim 7, wherein the control circuit (9; 109; 409) comprises a sensing interface (3), and wherein the first fixed sensing electrodes (10a; 410a; 510b) and the second fixed sensing electrodes (10b; 410b; 510b) are connected, respectively, to a first input and to a second input of the sensing interface (3) at least in a first operating configuration.

9. The device according to claim 8, wherein the control circuit (409) comprises a selector (430) configured to connect a first set of the first fixed sensing electrodes (410a) and of the second fixed sensing electrodes (410b) to the first input and to the second input of the sensing interface (3) in the first operating configuration and to a terminal of the driving stage (8) that supplies the actuation voltage (V_{A}) in a second operating configuration in stiction conditions.

10. The device according to claim 9, wherein the selector (430) is configured to connect a second set of the first fixed sensing electrodes (410a) and of the second fixed sensing electrodes (410b) to the first input and to the second input of the sensing interface (3) in the first operating configuration and to connect the first fixed sensing electrodes (410a) of the second set and the second fixed sensing electrodes (410b) of the second set to terminals of the driving stage (9) that supply an auxiliary actuation voltage (V_{AUX}) in the second operating configuration.

11. The device according to claim 8, wherein the driving stage (8) has terminals coupled to the first fixed sensing electrodes (10a; 510b) and to the second fixed sensing electrodes (10b; 510b) and is configured to supply an auxiliary actuation voltage (V_{AUX}) in a second operating configuration.

12. The device according to any one of claims 7 to 11, wherein the main direction (X) is parallel to a major face of the movable mass (11; 411; 511), the movement of the movable mass (11; 411; 511) is of the in-plane type, and the first fixed sensing electrodes (10a; 410a; 510b), the second fixed sensing electrodes (10b; 410b; 510b), and the movable sensing electrodes (11a) are capacitively coupled together in a parallel-plate configuration at least in the first operating configuration.

13. The device according to any one of claims 2 to 6, wherein:
the supporting body (511) comprises a substrate (514);
the movable mass (511) is constrained to the supporting body (514) in a way rocking about an axis of rotation (R) that is non-centroidal and parallel to major faces of the movable mass (511), a movement of the movable mass (511) being of the out-of-plane type;
the supporting body (511) comprises a first sensing electrode (510a) and a second sensing electrode (510b), arranged on the substrate (514) and capacitively coupled to the movable mass (511); and
the movable mass (511) defines a movable sensing electrode.

14. The device according to any one of claims 2 to 13, comprising a plurality of recovery electrodes (18; 218; 318; 518) on the supporting body (10; 410; 510), capacitively coupled to respective recovery portions (11b; 511b) of the movable mass (11; 411; 511).

15. A method for controlling a MEMS (MicroElectroMechanical System) device comprising a supporting body (10; 410; 510 and a movable mass (11; 411; 511), constrained to the supporting body (10; 410; 510) by flexures (12; 512) so as to be able to oscillate in a main direction (X; X');
the method comprising:
detecting stiction conditions, in which the movable mass (11; 411; 511) is stuck to the supporting body (10; 410; 510) by a stiction force (F_{S}); and
in response to recognition of the stiction conditions, applying to the movable mass (11; 411; 511) an electrostatic actuation force (F_{A}), transverse to the main direction (X; X');
wherein the actuation force (F_{A}) is a variable force with an actuation frequency band (ΔF_{A}) containing at least one resonance frequency (F_{R}), in an actuation direction (D_{A}) transverse to the main direction (X; X'), of a mechanical system comprising the movable mass (11; 411; 511) stuck to the supporting body (10; 410; 510), so that the actuation force (F_{A}) will activate at least one natural vibrational mode in a vibration direction transverse to the main direction (X).
